# EUROPEAN PATENT APPLICATION

(11) **EP 4 187 576 A1**
(43) Date of publication of application: **31.05.2023**
(21) Application number: 20945785.2
(22) Date of filing: 24.07.2020
(51) Int. Cl.: H01L 21/205, H01L 23/373

(54) **HETEROEPITAXIAL STRUCTURE WITH A DIAMOND HEAT SINK**

(71) Applicant: Limited Liability Company "Wondercvd" Management Services, Dubai (AE)
(72) Inventor: ZANAVESKIN, Maksim Leonidovich, Moscow, 115407 (RU); ANDREEV, Aleksandr Aleksandrovich, Moscow, 119192 (RU); MAMICHEV, Dmitrij Aleksandrovich, Bryansk Bryanskaya obl., 241012 (RU); CHERNYKH, Igor Anatolyevich, Moscow, 117534 (RU); MAYBORODA, Ivan Olegovich, Azov Rostovskaya obl., 346783 (RU); ALTAKHOV, Aleksandr Sergeevich, . Stavropol Stavropolskij kraj, 355031 (RU); SEDOV, Vadim Stanislavovich, Moscow, 129343 (RU); KONOV, Vitalij Ivanovich, Moscow, 117218 (RU)
(74) Representative: Jeck, Jonathan
(86) International application number: PCT/RU2020/000391
(87) International publication number: WO 2022/019799

(57) **Abstract**

A heteroexpitaxial structure comprises a substrate having a silicon-on-insulator structure. Applied to one surface of a layer of single-crystal silicon having a surface orientation is a layer of polycrystalline diamond. Formed on the other surface of said layer of surface orientation single-crystal silicon of the silicon-on-insulator structure from which layers of a dielectric and another single-crystal silicon layer are first removed is an epitaxial structure of a semiconductor device based on wide-bandgap III-nitrides.

## Description

### TECHNICAL FIELD

The invention relates to semiconductor technology and can be used as active structures for manufacturing microwave devices and power electronic devices such as high-electron-mobility transistors (HEMT), bipolar junction transistors (BJT), heterojunction bipolar transistors (HBT), PIN diodes, Schottky diodes, rectifiers, and many others.

### BACKGROUND ART

Devices based on a heteroepitaxial structure (HES) such as AIGaN/GaN, InAI-GaN/GaN and others are widely used nowadays. HES layers are grown by epitaxial methods such as metal organic chemical vapor deposition (MOCVD), molecular beam epitaxy (MBE), hydride vapor phase epitaxy (HVPE), and others.

Unlike conventional semiconductor materials, wide bandgap III-nitrides have a hexagonal crystal lattice and are grown as thin heteroepitaxial structures on substrates.

Single-crystal gallium nitride substrates are the most consistent substrates for wide bandgap III-nitrides in terms of crystal lattice parameters. They still have a limited scope of application due to their small size (up to 50 mm), extremely high cost and limited thermal conductivity. For this purpose, sapphire (Al₂O₃), silicon carbide (SiC) and single-crystal silicon (Si) substrates, as well as composite substrates combining layers of different materials, are generally used in industries [1-3].

However, the power of devices manufactured by said method is limited by thermal conductivity of heteroepitaxial and transition layers, thermal boundary resistance and, to a significant degree thermal conductivity of the substrate on which they are grown. The maximum heat release is observed in a narrow (lateral length - 0.5-2.5 µm) near-surface (0.25 µm from the surface or less) region near a gate or control electrode. Thermal conductivity of materials in the vicinity (100 µm or less) of said region has the key effect on device parameters.

Technical solutions aimed at solving this problem are known in the prior art.

The prior art discloses a high-power microwave transistor based on gallium nitride [patent RU 2581726, published on 20 April 2016], comprising a substrate, a heteroepitaxial structure based on gallium nitride compounds, applied on a substrate, electrodes comprising a source, gate and drain applied on the heteroepitaxial structure and spatially separated from each other, a passivation dielectric film deposited on the heteroepitaxial structure between electrode contacts, a heat sink formed on the heteroepitaxial structure, and a heat-spreading layer. The substrate is made of high-resistance silicon. The heat-spreading layer is located between the drain contact and the heat sink.

The disadvantage of this technical solution is limited and nonuniform heat removal due to the heat sink is located only in the drain area, as well as the complex configuration of the heat sink.

The prior art discloses a semiconductor device and method for manufacturing said device [patent RU 2507634, published on 20 February 2014], comprising a thinned substrate of p-type single-crystal silicon with (111) plane orientation ((111) orientation), with a buffer layer of aluminum nitride (AIN) made on it, on top of which there is a thermally conductive substrate in the form of a deposited polycrystalline diamond layer with a thickness of at least 0.1 mm. On the other side of the substrate there is an semiconductor epitaxial structure based on wide bandgap III-nitrides, an AlGaN source, a gate, a AlGaN drain, ohmic contacts to the source and the drain, and a solder in the form of a layer comprising AuSn, a copper pedestal and a flange. There is a layer of insulating polycrystalline diamond between the source, gate and drain. The disadvantage of this technical solution is a high concentration of defects in the aluminum nitride layer, which causes similar defects in the diamond layer during its growth.

The common features with the subject invention are the formation of a semiconductor heteroepitaxial structure based on gallium nitride (GaN), the use of a polycrystalline CVD diamond and single-crystal silicon as a base substrate.

The prior art discloses a high-power microwave transistor with a multilayer epitaxial structure [patent RU 2519054, published on 10 June 2014], comprising a base silicone substrate, a thermally conductive polycrystalline diamond layer, an epitaxial structure based on wide bandgap III-nitrides, a buffer layer, a source, a gate, a drain and ohmic contacts. The thermally conductive polycrystalline diamond layer has a thickness of 0.1-0.15 mm. An auxiliary thermally conductive polycrystalline diamond layer, a barrier layer of hafnium dioxide and an auxiliary barrier layer of aluminum oxide are arranged in series on the surface of the epitaxial structure between the source, gate and drain. The barrier layers of hafnium dioxide and aluminum oxide have a total thickness of 1.0-4.0 nm and are located under the gate, directly on the epitaxial structure as a layer of solid AlGaN solution with n-type conductivity.

The disadvantage of this technical solution is a high concentration of defects in the layer of aluminum nitride/hafnium nitride, which may be translated into the diamond layer during its growth.

The common features with the subject invention are the formation of a semiconductor heteroepitaxial structure based on GaN, the use of a polycrystalline CVD diamond and single-crystal silicon as a base substrate.

The prior art discloses a high-power microwave transistor [patent RF 2519055, published on 10 June 2014], comprising a base silicone substrate, a thermally conductive polycrystalline diamond layer, an epitaxial structure based on wide bandgap III-nitrides, a buffer layer, a source, a gate, a drain and ohmic contacts. The base silicon substrate has a thickness of less than 10 µm; the layer of thermally conductive polycrystalline diamond has a thickness of at least 0.1 mm; an additional layer of thermally conductive polycrystalline diamond and a barrier layer of hafnium dioxide with a thickness of 1.0-4.0 nm are arranged in series on the surface of the epitaxial structure. The barrier layer of hafnium dioxide is located under the gate directly on the epitaxial structure as a layer of solid AlGaN solution with n-type conductivity.

The disadvantage of this technical solution is also a high concentration of defects in the layer of aluminum nitride/hafnium nitride, which causes similar defects in the diamond layer during its growth.

The common features with the claimed heteroepitaxial structure is the base silicone substrate, the thermally conductive polycrystalline diamond layer, and the epitaxial structure based on wide bandgap III-nitrides.

The prior art discloses a method for manufacturing a high-power microwave transistor [patent RU 2534442, published on 27 November 2014], comprising deposition of a solder layer to the flange, formation of a pedestal, deposition of a sublayer fixing the transistor die to the pedestal, growth of auxiliary epitaxial layers on the base substrate of p-type single-crystalline silicon with (111) plane orientation, deposition of a base layer and buffer layer for growing an semiconductor epitaxial structure based on wide bandgap III-nitrides, deposition of a thermally conductive layer of polycrystalline CVD diamond to the base layer, removal of the base substrate with auxiliary epitaxial layers up to the base layer, growing a heteroepitaxial structure based on wide bandgap III-nitrides on the base layer, and formation of a source, gate and drain. A thermally conductive layer of CVD polycrystalline diamond is used as a pedestal, to the near-surface region of which nickel is implanted and annealed. Before forming the source, gate and drain, an additional layer of insulating polycrystalline diamond and additional layers of hafnium dioxide and aluminum oxide, with a total thickness of 1.0-4.0 nm, are deposited in series over the transistor crystal.

The disadvantage of this technical solution is a relatively high concentration of defects in the AlₓGa₁₋ₓN layer, which are translated into the diamond layer during its growth.

The common features with the subject method for manufacturing the heteroepitaxial structure are the formation of auxiliary epitaxial layers on the base substrate of single-crystalline silicon with (111) plane orientation, the deposition of the base layer and the buffer layer for growing a semiconductor epitaxial structure based on wide bandgap III-nitrides, the deposition of the thermally conductive layer of polycrystalline CVD diamond to the base layer, removal of the base substrate with auxiliary epitaxial layers up to the base layer, growing a heteroepitaxial structure based on wide bandgap III-nitrides on the base layer.

The closest analogue of the claimed heteroepitaxial structure with a diamond heat sink is the structure disclosed in [patent RF 2368031, published on 20 September 2009, Official Journal No. 26], comprising a base substrate, a thermally conductive polycrystalline diamond layer, and a semiconductor epitaxial structure based on wide bandgap III-nitrides.

The closest analogue of the claimed method is the method for manufacturing a semiconductor device disclosed in [patent RF 2368031, published on 20 September 2009], comprising growing auxiliary epitaxial layers and a semiconductor epitaxial structure based on wide bandgap III-nitrides on a base substrate of polycrystalline diamond. Auxiliary epitaxial layers, one of which is a base layer for growing the semiconductor epitaxial structure based on wide bandgap III-nitrides, are formed on the surface of the base substrate; the polycrystalline diamond is grown on the auxiliary epitaxial layers; and after growing the diamond, the base substrate with auxiliary epitaxial layers is removed up to the base layer, on which the semiconductor epitaxial structure based on wide bandgap III-nitrides is grown. In order to grow an epitaxial III-nitride structure, an AlₓGa₁₋ₓN layer, where 0≤x≤1, is preferably grown as a base layer in the system of auxiliary epitaxial layers. The method simplifies the manufacturing process, increases the power of devices and practically eliminates bending of the structure.

A disadvantage of this method is that the thermally conductive layer of polycrystalline diamond is grown on a solid solution layer of AlₓGa₁₋ₓN, aluminum nitride (AIN) or gallium nitride (GaN). Defects in the above layers are highly concentrated and, during their growth, are translated into the diamond layer and significantly reduce its thermal conductivity. In addition, the thermal conductivity of the base layer used in the method is substantially lower than the thermal conductivity of single-crystal silicon, while the base layer/diamond transition has a sufficiently high thermal resistance.

The common features with the subject method are growing a polycrystalline diamond and a semiconductor epitaxial structure based on wide bandgap III-nitride on the base multilayer substrate and removing part of the base substrate layers up to the base layer after the growth of the polycrystalline diamond.

### SUMMARY OF THE INVENTION

The technical problem in creating heteroepitaxial structures and methods of manufacturing them is insufficiently efficient removal of heat from semiconductor structures due to a thin layer of thermally conductive polycrystalline diamond. On the other hand, the excessive thickness of the material layer also contributes to thermal resistance.

The main object of the claimed group of inventions is to create a semiconductor heteroepitaxial structure based on wide bandgap III-nitrides with a diamond heat sink and a high-quality layer of polycrystalline diamond on single-crystal silicon substrates, as well as to reduce the active area of the device and decrease the thermal resistance of the die-package.

The technical result is improved heat removal from a semiconductor device structure achieved by increasing the thermal conductivity coefficient of the structure and reducing the thermal resistance of the die-package.

By improving heat removal from the semiconductor device, the following practically significant results can be achieved: creation of devices and instruments with higher output power, and/or improved linearity characteristics, noise factor and/or lifetime, and/or more compact dimensions.

The subject invention makes it possible to simplify a process of manufacturing semiconductor devices and to scale up the manufacturing process to substrates of different diameters up to 300 mm.

The technical result is achieved as follows: according to the prior method for manufacturing a heteroepitaxial structure with a diamond heat sink, in which a polycrystalline diamond and a semiconductor epitaxial structure based on wide bandgap III-nitrides are grown on a base multilayer substrate, part of the base substrate layers is removed up to the base layer after the growth of the polycrystalline diamond; a multilayer substrate of a SOI structure is used as a base substrate; a polycrystalline diamond layer is grown on one surface of the single-crystal silicon layer with (111) surface orientation of the SOI structure; other base substrate layers of the SOI structure are removed after the deposition of the polycrystalline diamond layer; and the semiconductor epitaxial structure based on wide bandgap III-nitrides is formed on the other surface of the silicon layer with (111) surface orientation.

The technical result is also achieved as follows: in the heteroepitaxial structure comprising a base substrate, a thermally conductive polycrystalline diamond layer and a semiconductor epitaxial structure based on wide bandgap III-nitrides, the base substrate is made on the basis of a SOI structure; a polycrystalline diamond layer is deposited on one surface of the single-crystal silicon layer with (111) surface orientation of the SOI structure; and a semiconductor epitaxial structure based on wide bandgap III-nitrides is formed on the other surface of the single-crystal silicon layer with (111) surface orientation of the SOI structure with removed dielectric and single-crystal silicon layers.

Preferably, 200-1,200 µm thick single-crystal silicon (c-Si) with (111), (110) or (100) surface orientations is used as one of the base substrate layers, and it is removed by etching silicon in xenon difluoride vapor or by liquid etching.

Preferably, a silicon dioxide structure with a thickness of < 500 nm is used as a dielectric layer in the SOI structure, and it is removed by liquid etching in hydrofluoric acid solutions or by plasma-chemical etching in carbon tetrafluoride and oxygen mixture (CF₄/O₂).

Preferably, the thickness of the polycrystalline diamond layer is not less than 50 µm.

It is desirable that, the polycrystalline diamond layer is formed after the deposition of a monolayer of 5-10 nm diamond nanoparticles on the surface of silicon with (111) surface orientation; and the monolayer of diamond nanoparticles is deposited on the surface of silicon (111) in an ultrasonic bath of modified 3% (w/w) aqueous suspension of diamond nanoparticles.

Preferably, the temperature of the base substrate during the growth of the polycrystalline diamond layer is maintained within 750-1,000°C.

Preferably, the thickness of the base substrate after the deposition of polycrystalline diamond is decreased to 0.2 µm.

Optimally, the epitaxial semiconductor structure is formed on the basis of wide bandgap III-nitrides in the form of AlₓGa₁₋ₓN/GaN/AlₓGa₁₋ₓN, where 0≤x≤1.

It is desirable that, the GaN layer in the semiconductor epitaxial structure based on wide bandgap III-nitrides is doped with a p-type impurity.

Preferably, the semiconductor epitaxial structure is formed on the silicon layer with (111) surface orientation by forming AlₓGa₁₋ₓN (0<x<1) buffer layers and growing a gallium nitride (GaN) layer on their surface, followed by the formation of AIN or AlₓGa₁₋ₓN (0.2≤x≤1) barrier layers.

Preferably, the polycrystalline diamond layer is formed on the surface of high-purity silicon with (111) surface orientation and roughness *Rₐ <* 0.1 nm with a monolayer of 5-10 nm diamond nanoparticles.

The claimed method and heteroepitaxial structure based on a SOI structure with a high-quality polycrystalline diamond layer grown on a layer of high-purity single-crystal silicon of low thickness (for example, up to 200 nm) makes it possible to significantly increase heat removal from the heteroepitaxial structure, since the thermal conductivity of said silicon layer is comparable to thermal conductivity of bulk material (148 W/(m*K)), as follows from [4], according to which the thermal conductivity of thin layers of single-crystal silicon is close to the thermal conductivity of bulk material, while the thermal contact resistance of the silicon/diamond transition is 7-20 m²*K/GW [5, 6]. The growth surface of polycrystalline diamond then can be used to mount the obtaining structure to a device package (e.g., a transistor).

Said result may be slightly inferior to the results obtained for GaN layers on single-crystal bulk AIN substrates with a thermal conductivity of 180 W/(m*K), and GaN with a thermal conductivity of 130 W/(m*K), but, in contrast to them, it may be implemented for substrates of large diameters (100 mm or more). Also, the disclosed method does not use a layer of amorphous, highly disturbed material, for example an amorphous silicon nitride (SiNₓ) layer with a low thermal conductivity (2 W/(m*K)) and a high thermal contact resistance of the transition (12-50 m²*K/GW) [6, 7].

As disclosed in the prior art, SOI (silicon-on-insulator) structures can be used in semiconductors to manufacture devices with improved performance compared to similar devices based on conventional silicon wafers. However, SOI structures in semiconductor electronics have been developed and are used primarily to reduce power consumption of microelectronic devices, increase their performance due to reduced parasitic capacitance, increase their radiation resistance and provide reliable isolation of their workspace from the rest of the circuit and substrate. In this case, the multilayer SOI structure is preserved in the final semiconductor product.

In the subject invention, the SOI structure is only used as a substrate the layers of which are subsequently removed up to c-Si (111), and its use as a base substrate is aimed at improving thermal conduction properties of the resulting device and therefore improving its performance.

The prior art does not disclose any possibility of using a SOI structure to improve heat removal from a semiconductor structure by growing a diamond film on the smooth surface of high-purity single crystal silicon layer, e.g. with a thickness of up to 200 nm, and therefore reducing the thermal contact resistance of the silicon/diamond transition.

### BRIEF DESCRIPTION OF DRAWINGS

FIG. 1 illustrates a base substrate of the SOI structure.
FIG. 2 illustrates a base substrate of the SOI structure with a deposited polycrystalline diamond layer.
FIG. 3 illustrates the final epitaxial structure with a diamond heat sink.

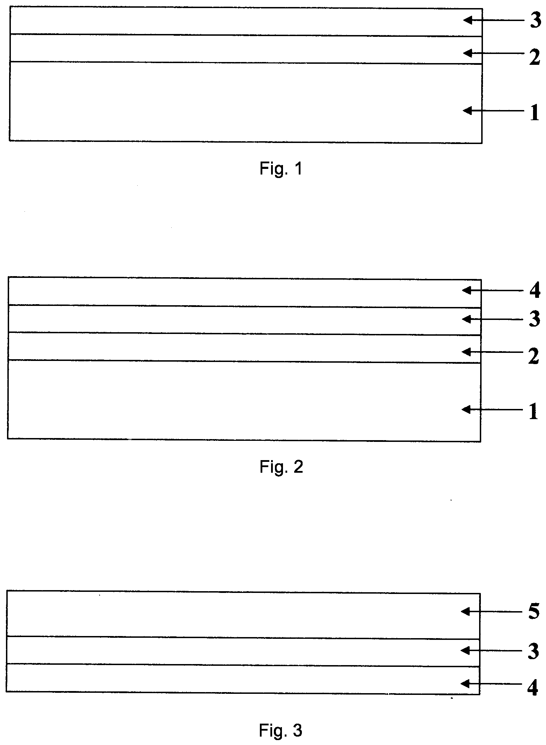

A SOI (silicon-on-insulator) substrate of the structure illustrated in Fig. 1, is used as a base substrate on which a polycrystalline diamond layer and subsequently a heteroepitaxial structure are formed. Layer 1 is single-crystal silicon (c-Si) with (111) surface orientation or (110) or (100). Layer 2 is silicon dioxide (SiO₂); Layer 3 is single-crystal silicon with (111) surface orientation.

A polycrystalline diamond layer (Layer 4) is deposited on Layer 3 of the base substrate by plasma-enhanced chemical vapor deposition (PECVD) (FIG. 2).

A heteroepitaxial structure based on wide bandgap III-nitrides such as AIGaN/GaN (Layer 5), which serves as the basis for the future semiconductor device, is grown on the surface of silicon with (111) surface orientation (Layer 3) (FIG. 3).

### PREFERRED EMBODIMENTS

A SOI (silicon-on-insulator) structure is used as a base substrate on which a polycrystalline diamond layer and subsequently a heteroepitaxial structure are formed. Layer 1 is single-crystal silicon (c-Si) with (111) surface orientation or (110) or (100) and with a thickness of 200-1,200 µm. Layer 2 is silicon dioxide (SiO₂) with a thickness of less than 500 nm (optimal thickness - 300 nm). Layer 3 is single-crystal silicon with (111) surface orientation and with a thickness of less than 2 µm (optimal thickness - 500 nm).

A polycrystalline diamond layer (Layer 4) with a thickness of at least 50 µm is deposited on Layer 3 of the base substrate by plasma-enhanced chemical vapor deposition (PECVD). The polycrystalline diamond layer is grown in two main steps: creating nucleation centers and synthesizing a diamond film in a microwave reactor. Prior to loading the substrate into the microwave reactor, it is seeded with diamond particles. Diamond nanoparticles are deposited on the silicon surface in order to create nucleation sites. In order to obtain a homogeneous film, it is necessary that diamond nanoparticles are uniformly distributed across the substrate surface. For this purpose, aqueous or alcoholic suspensions of ultra-dispersed (detonation) diamond with 5-50 nm diamond nanoparticles are used. The substrate is immersed in said suspension and placed in an ultrasonic bath for 15 minutes. Said processing provides high nucleation density (number of diamond particles per unit area) on the order of 10⁹-10¹⁰ cm⁻² and good uniformity of particle distribution across the surface. Said substrate is then placed in a microwave plasma chemical reactor in which the diamond film is synthesized in methane-hydrogen mixture. Gases H₂ (99.99999%) and CH₄ (99.995%) are used. Polycrystalline diamond films are synthesized at a microwave power of 2.5-3.5 kW, chamber pressure of 50-70 torr, H₂ flow rate of 300-500 cm³/min, CH₄ flow rate of 2 to 20 cm³/min and substrate temperature of 750-1,000 °C.

After the polycrystalline diamond layer is grown, the single-crystal silicon layer (Layer 1) and the silicon dioxide layer (Layer 2) are removed. Layer 1 is removed by etching silicon in xenon difluoride vapor (XeF₂), which has high silicon etching selectivity with respect to most standard semiconductor materials. XeF₂ with 99.999% purity is used for etching. Silicon was etched by the pulse method (the time of one pulse is 20-120 seconds) at a XeF₂ vapor pressure of 2,000-3,000 mTorr. Under said conditions, the etching rate is about 270 nm/min for a 4-inch substrate. The total etching time and the number of etching cycles are selected depending on the thickness of Layer 1 for its complete removal.

Layer 2 is removed by well-known liquid etching techniques in hydrofluoric acid solutions or dry plasma-chemical etching in fluorine plasma. For example, a chemically pure buffer solution can be used to remove silicon dioxide by liquid etching (HF:NH₄F=12.5:87.5%). The etching rate of silicon dioxide in said solution was 80-100 nm/min. The etching time is selected depending on the thickness of Layer 2 for its complete removal. Also, the silicon dioxide layer can be removed using the plasma-chemical method, by etching in plasma containing CF₄/O₂ gas mixture. The purity of both carbon tetrafluoride (CF₄) and oxygen is 99.999%. Etching is performed at a pressure of 30 mTorr, CF₄ flow rate of 20 standard cm³/min, O₂ flow rate of 2 standard cm³/min, and power of 75 W. Under said conditions, the etching rate of silicon dioxide is 30-50 nm/min. The etching time is selected depending on the thickness of Layer 2 for its complete removal.

At the next process step, a heteroepitaxial structure based on wide bandgap III-nitrides, such as AIGaN/GaN (Layer 5), which serves as the basis for the future semiconductor device, is grown on the surface of silicon with (111) surface orientation (Layer 3). The heteroepitaxial structure is most often obtained by molecular beam epitaxy method or chemical vapor deposition.

In order to obtain an AIGaN/GaN heterostructure by molecular beam epitaxy, Ga (99.9995%) and Al (99.999%) sources, as well as ammonia NH₃ (99.99995%) are used. The formation of the structure begins with the growth of AlₓGa₁₋ₓN buffer layers, where 0≤x≤1, with a total thickness of 0.2-1.4 µm on the surface of the silicon substrate. The buffer layers are grown at a temperature gradient of 1,150 to 800 °C. During the growth of the buffer layers, the pressure is maintained in the range of 5·10⁻⁵ to 3·10⁻³ Pa. A 0.1-5 µm gallium nitride (GaN) layer is then grown at a temperature of 800 °C and pressure of no more than 3·10⁻³ Pa. Next, 2-30 nm thick AIN or AlₓGa₁₋ₓN barrier layers (where 0.2<x<1) are grown at 800° C. A dielectric SiO₂ or Si₃N₄ layer with a thickness of 3-10 nm can be then deposited at 800 °C.

In order to obtain a heterostructure by gas-phase epitaxy, trimethylaluminum (99.999%), trimethylgallium (99.999%) and ammonia (99.9999%) are used as precursors. Hydrogen (99.9999%) is used as a carrier gas. 0.2-1.4 µm thick AlₓGa₁₋ₓN buffer layers (where 0≤x≤1) are first grown on the silicon substrate at 795-925 °C. During the growth of the buffer layers, the pressure is maintained at 5 kPa. Then, a 0.1-5 µm thick GaN layer is formed at 930 °C and 10 kPa. 2-30 nm AIN or AlₓGa₁₋ₓN barrier layers (where 0.2<x<1) are then deposited at 900-930° C. Finally, a dielectric SiO₂ or Si₃N₄ layer with a thickness of 3-10 nm can be deposited at 800 °C.

The thermal conductivity of the resulting heterostructure will substantially depend on the thickness and composition of its layers. In this case, there will be no significant dependence of the thermal conductivity of the heterostructure on the manufacturing method.

The result is a heteroepitaxial structure with a high-quality polycrystalline diamond layer, grown on high-purity single-crystal silicon layer of low thickness (not less than 200 nm), which makes it possible to significantly increase the heat removal from the heteroepitaxial structure, because the thermal conductivity of said silicon layer corresponds to the thermal conductivity of bulk material (148 W/(m*K)), while the thermal contact resistance of the silicon/diamond transition is 7-20 m²*K/GW.

The growth surface of polycrystalline diamond then can be used to mount the resulting semiconductor structure to a device package (e.g., a transistor). In addition, the high crystalline quality of all layers of the semiconductor structure with a diamond heat sink increases the yield of semiconductor devices.

The manufacturing method described above can easily be scaled up to manufacture substrates of different diameters up to 300 mm.

### EMBODIMENTS OF THE INVENTION

### Embodiment 1.

Using an experimental setup for plasma-enhanced chemical vapor deposition, 200 µm thick polycrystalline diamond was grown on a silicon substrate with a 0.1 µm thick AIN base epitaxial layer. Said diamond was grown in a microwave discharge using reaction mixture CH₄(10%)/H₂(88.5%)/O₂(1.5%) according to the disclosed prototype method. The deposition conditions were as follows: chamber pressure - 95 Torr, hydrogen flow rate - 0.53 l/min, input microwave power- 4.6 kW, substrate temperature - 940 °C.

After the polycrystalline diamond layer is formed, the silicon substrate was removed, and an epitaxial heterostructure based on III-nitrides was grown on the other side of the AIN base layer using the prior art methods.

As a result, due to a high concentration of defects in the AIN layer and their subsequent translation into both the layers of the heteroepitaxial structure and the diamond layer, the thermal conductivity of the heterostructure with a diamond heat sink formed according to the prototype was 190 W/(m*K), while the thermal resistance was 395 m²*K/GW.

### Embodiment 2.

A SOI structure was used as a base substrate. It comprised a 200 µm thick single-crystal silicon (c-Si) with (111) surface orientation as Layer 1, a 300 nm thick silicon dioxide (Si0₂) as Layer 2 and a 500 nm thick single-crystal silicon with (111) surface orientation as Layer 3.

A 50 µm thick polycrystalline diamond layer (Layer 4) was applied to Layer 3 of the base substrate by plasma-enhanced chemical vapor deposition (PECVD). The polycrystalline diamond layer was grown in two main steps: creating nucleation centers and synthesizing a diamond film in a microwave reactor. Prior to loading the substrate into the microwave reactor, it was seeded with diamond nanoparticles. The substrate was then placed in a microwave plasma chemical reactor in which the diamond film was synthesized in methane-hydrogen mixture using H₂ (99.99999%) and CH₄ (99.995%) gases. The polycrystalline diamond film was synthesized at a microwave power of 3.5 kW, chamber pressure of 70 Torr, H₂ flow rate of 400 cm³/min, CH₄ flow rate of 10 cm³/min and substrate temperature of 800 °C.

After the polycrystalline diamond layer was deposited, the single-crystal silicon layer (Layer 1) and the silicon dioxide layer (Layer 2) were removed. Layer 1 was removed by etching silicon in xenon difluoride vapor (XeF₂) with 99.999% purity using the pulse method (time of one pulse - 60 seconds) at a XeF₂ vapor pressure of 3,000 mTorr. The etching rate was about 270 nm/min for a 4-inch substrate. The etching time and the number of etching cycles were selected so that Layer 1 could be completely removed. Layer 2 was removed by liquid etching using a chemically pure buffer solution (HF:NH₄F=12.5:87.5%). The etching rate of silicon dioxide in said solution was 90 nm/min. The etching time was selected so that Layer 2 could be completely removed.

Next, a heteroepitaxial structure based on wide bandgap III-nitrides, such as AlGaN/GaN (Layer 5), was grown on the surface of silicon with (111) surface orientation (Layer 3).

The heteroepitaxial structure was formed by molecular beam epitaxy using Ga (99.9995%) and Al (99.999%) sources, as well as ammonia NH₃ (99.99995%). The formation of the structure began with the growth of AlₓGa₁₋ₓN buffer layers (where 0≤x≤1) with a total thickness of 0.2 µm on the surface of the silicon substrate. The buffer layers were grown at a temperature gradient of 1,150 to 800 °C. During the growth of the buffer layers, the pressure is maintained in the range of 5·10⁻⁵ to 3·10⁻³ Pa. Then, a 0.1 µm thick gallium nitride (GaN) layer was grown at a temperature of 800 °C and pressure of no more than 3·10⁻³ Pa. Next, 2 nm thick AIN or AlₓGa₁₋ₓN barrier layers (where 0.2<x<1) were formed at 800° C. A 3 nm thick SiO₂ dielectric layer was then deposited at 800° C.

The result was the heteroepitaxial structure with a diamond heat sink having a thermal conductivity of 315 W/(m*K) and thermal resistance of 165 m²*K/GW. Embodiment 3.

The polycrystalline diamond layer and heteroepitaxial structure were formed as described in Embodiment 2, but using the following methods and under the following operating conditions.

A SOI structure was used as a base substrate. It comprised a 1,200 µm thick single-crystal silicon (c-Si) with (110) surface orientation as Layer 1, a 500 nm thick silicon dioxide (Si0₂) as Layer 2 and a 2 µm thick single-crystal silicon with (111) surface orientation as Layer 3.

A 50 µm thick polycrystalline diamond layer (Layer 4) was deposited on Layer 3 of the base substrate by plasma-enhanced chemical vapor deposition (PECVD).

After the polycrystalline diamond layer was grown, the single-crystal silicon layer (Layer 1) and the silicon dioxide layer (Layer 2) were removed. Layer 1 was removed by etching silicon in xenon difluoride vapor (XeF₂) with 99.999% purity using the pulse method (time of one pulse - 60 seconds) at a XeF₂ vapor pressure of 3,000 mTorr. Under these conditions, the etching rate was about 270 nm/min for a 4-inch substrate. The etching time and the number of etching cycles were selected so that Layer 1 could be completely removed. Layer 2 was removed using the plasma-chemical method by etching in plasma containing CF₄/O₂ gas mixture. The purity of both carbon tetrafluoride (CF₄) and oxygen was 99.999%. Etching was performed at a pressure of 30 mTorr, CF₄ flow rate of 20 standard cm³/min, O₂ flow rate of 2 standard cm³/min, and power of 75 W. The etching rate of silicon dioxide was 50 nm/min. The etching time was selected so that Layer 2 could be completely removed.

Next, a heteroepitaxial structure based on wide bandgap III-nitrides such as AlGaN/GaN (Layer 5) was grown on the surface of silicon with (111) surface orientation (Layer 3). The heteroepitaxial structure was formed by molecular beam epitaxy using Ga (99.9995%) and Al (99.999%) sources, as well as ammonia NH₃ (99.99995%). The formation of the structure began with the growth of AlₓGa₁₋ₓN buffer layers (where 0≤x≤1) with a total thickness of 1.4 µm on the surface of the silicon substrate. The buffer layers were grown at a temperature gradient of 1,150 to 800 °C. During the growth of the buffer layers, the pressure is maintained in the range of 5·10⁻⁵ to 3·10⁻³ Pa. A 5 µm thick gallium nitride (GaN) layer was grown at a temperature of 800 °C and pressure of no more than 3·10⁻³ Pa. Next, 30 nm AIN barrier layer were deposited at 800° C. Then, a 10 nm thick Si₃N₄ dielectric layer was deposited at 800 °C.

The result is the heteroepitaxial structure with a diamond heat sink having a thermal conductivity of 277 W/(m*K) and thermal resistance of 290 m²*K/GW.

### Embodiment 4.

The polycrystalline diamond layer was obtained as described in Embodiment 2, but using the following methods and under the following operating conditions.

A SOI structure was used as a base substrate. It contained 500 µm thick single-crystal silicon (c-Si) with (100) surface orientation as Layer 1, 300 nm thick silicon dioxide (Si0₂) as Layer 2 and 500 nm thick single-crystal silicon with (111) surface orientation as Layer 3.

A 200 µm thick polycrystalline diamond layer (Layer 4) was deposited on Layer 3 of the base substrate by plasma-enhanced chemical vapor deposition (PECVD).

After the polycrystalline diamond layer was deposited, the single-crystal silicon layer (Layer 1) and the silicon dioxide layer (Layer 2) were removed. Layer 1 was removed by etching silicon in xenon difluoride vapor (XeF₂) with 99.999% purity using the pulse method (time of one pulse - 60 seconds) at a XeF₂ vapor pressure of 3,000 mTorr. The etching rate was about 270 nm/min for a 4-inch substrate. The etching time and the number of etching cycles were selected so that Layer 1 could be completely removed. Layer 2 was removed by liquid etching using a chemically pure buffer solution (HF:NH₄F=12.5:87.5%). The etching rate of silicon dioxide in said solution was 90 nm/min. The etching time was selected for the complete removal of Layer 2.

Layer 3 was then thinned to a thickness of 200 nm by mechanical grinding/polishing of silicon.

In order to obtain a heterostructure by gas-phase epitaxy, trimethylaluminum (99.999%), trimethylgallium (99.999%) and ammonia (99.9999%) were used as precursors. Hydrogen (99.999%) was used as a carrier gas. AlₓGa₁₋ₓN buffer layers (where 0≤x≤1) with a thickness of 1 µm were first grown on the silicon substrate at 795-925 C. During the growth of the buffer layers, the pressure was maintained at 5 kPa. A 5 µm GaN layer was then formed at 930 °C and 10 kPa. AIN or AlₓGa₁₋ₓN barrier layers (where 0.2<x<1) with a thickness of 30 nm are then grown at 900 °C. Finally, a 10 nm thick SiO₂ dielectric layer was deposited at 900 °C.

The result was the heteroepitaxial structure with a diamond heat sink having a thermal conductivity of 514 W/(m*K) and thermal resistance of 201 m²*K/GW.

The claimed group of inventions can be widely used in semiconductor technology for manufacturing microwave devices and power electronic devices such as high-electron-mobility transistors (HEMT), bipolar junction transistors (BJT), heterojunction bipolar transistors (HBT), PIN diodes, Schottky diodes, rectifiers, etc., by improving heat removal from semiconductor structures. This allows improve the performance of semiconductor devices and to scale up the manufacturing process based on the subject method to substrates of different diameters up to 300 mm.

### REFERENCES

1. Y.V. Fedorov Wide bandgap heterostructures (Al, Ga, In)N and devices based on them operating in the millimeter wavelength range // Electronics: NTB. - 2011. - No. 2, P. 92-107.
2. Bulk GaN substrate market growing at 10% CAGR to $100m in 2022, from 60,000 wafers in 2016 // Semiconductor Today. Compounds&Advanced Silicon. - 2017. - March/April. - Vol. 12. - Issue 2, P.78-79.
3. A. Tanaka et al. Structural and electrical characterization of thick GaN layers on Si, GaN, and engineered substrates // J. Appl. Phys. - 2019. - vol. 125 - P.082517.
4. M. Asheghi et al. Temperature-Dependent thermal conductivity of single-crystal silicon layers in SOI Substrates // Journal of Heat Transfer. - 1998. - Vol. 120. - P. 30-36.
5. Zhe Cheng at al. Tunable thermal energy transport across diamond membranes and diamond-Si interfaces by nanoscale graphoepitaxy //ACS Appl. Mater. Interfaces - 2019. - Vol. 11. - No 20. - P. 18517-18527.
6. T.L. Bougher et al. Thermal boundary resistance in GaN films measured by time domain thermoreflectance with robust Monte Carlo uncertainty estimation // Nanoscale And Microscale Thermophysical Engineering. - 2016. - Vol. 20. - No. 1. - P. 22-32.
7. H. Sun et al. Reducing GaN-on-diamond interfacial thermal resistance for high power transistor applications // AIP Applied Physics Letters. - 2015. - Vol. 106. - Iss. 11, P.111906.

## Claims

1. A method for manufacturing a heteroepitaxial structure with a diamond heat sink for semiconductor devices, in which a polycrystalline diamond and a semiconductor epitaxial structure based on wide bandgap III-nitrides are grown on a base multilayer substrate, and part of the base substrate layers is removed up to the base layer, wherein a multilayer substrate of a SOI structure is used as a base substrate, on one surface of the single-crystal silicon layer with (111) surface orientation of the SOI structure, a polycrystalline diamond layer is grown, another single-crystal silicon layer and the silicon dioxide layer of the SOI structure are removed after the deposition of the polycrystalline diamond layer, while the semiconductor epitaxial structure based on wide bandgap III-nitrides is formed on the other surface of the single-crystal silicon layer with (111) surface orientation.

2. The method of claim 1, wherein a 200-1,200 µm single-crystal silicon (c-Si) with (111) surface orientation, or (110) or (100) is used as one of the base substrate layers of the SOI structure, and it is removed by etching silicon in xenon difluoride vapor or by liquid etching.

3. The method of claim 1, wherein a silicon dioxide structure with a thickness of no more than 500 nm is used as a dielectric layer, and it is removed by liquid etching in hydrofluoric acid solutions or by plasma-chemical etching in carbon tetrafluoride and oxygen mixture (CF₄/O₂).

4. The method of claim 1, wherein the preferred thickness of the polycrystalline diamond layer is not less than 50 µm.

5. The method of claim 1, wherein the polycrystalline diamond layer is formed after the deposition of a monolayer of 5-10 nm diamond nanoparticles on the surface of silicon with (111) surface orientation.

6. The method of claim 1, wherein the monolayer of diamond nanoparticles is deposited on the surface of silicon (111) in an ultrasonic bath of modified 3% (w/w) aqueous suspension of diamond nanoparticles.

7. The method of claim 1, wherein the temperature of the base substrate during the growth of the polycrystalline diamond layer is maintained within 750-1,000 °C.

8. The method of claim 1, wherein the thickness of the single-crystal silicon layer with (111) surface orientation is reduced up to least 0.2 µm after the application of polycrystalline diamond.

9. The method of claim 1, wherein the epitaxial semiconductor structure is formed on the basis of wide bandgap III-nitrides in the form of AlₓGa₁₋ₓN/GaN/AlₓGa₁₋ₓN (where 0≤x≤1).

10. The method of claim 9, wherein the GaN layer in the semiconductor epitaxial structure based on wide bandgap III-nitrides is doped with a p-type impurity.

11. The method of claim 9, wherein the semiconductor epitaxial structure is formed on a silicon layer with (111) surface orientation by forming AlₓGa₁₋ₓN buffer layers (where 0<x<1) and growing a gallium nitride (GaN) layer on the buffer layers, followed by the deposition of AlN or AlₓGa₁₋ₓN barrier layers (where 0.2≤x≤1).

12. The heteroepitaxial structure with a diamond heat sink for semiconductor devices, containing a base substrate, a polycrystalline diamond layer and a semiconductor epitaxial structure based on wide bandgap III-nitrides, wherein the base substrate is based on a SOI structure, a polycrystalline diamond layer is deposited on one surface of the single-crystal silicon layer with (111) surface orientation of the SOI structure, and the semiconductor epitaxial structure based on wide bandgap III-nitrides is applied on the other surface of the single-crystal silicon layer with (111) surface orientation of the SOI structure with previously removed dielectric layer and the other single-crystal silicon layer.

13. The heteroepitaxial structure of claim 12, wherein the thickness of the polycrystalline diamond layer is not less than 50 µm.

14. The heteroepitaxial structure of claim 12, wherein the epitaxial semiconductor structure is formed on the basis of wide bandgap III-nitrides in the form of AlₓGa₁₋ₓN/GaN/AlₓGa₁₋ₓN (where 0≤x≤1).
